# EUROPÄISCHE PATENTSCHRIFT

(11) **EP 1 155 604 B1**
(45) Veröffentlichungstag und Bekanntmachung des Hinweises auf die Patenterteilung: **27.11.2002**
(21) Anmeldenummer: 00910525.5
(22) Anmeldetag: 02.02.2000
(51) Int. Cl.: H05K 13/04

(54) **VORRICHTUNG ZUM BESTÜCKEN VON SUBSTRATEN MIT ELEKTRISCHEN BAUELEMENTEN**
DEVICE FOR FITTING SUBSTRATES WITH ELECTRICAL COMPONENTS
DISPOSITIF POUR METTRE EN PLACE DES COMPOSANTS ELECTRIQUES SUR DES SUBSTRATS

(30) Priorität: 25.02.1999 DE 19908206
(43) Veröffentlichungstag der Anmeldung: 21.11.2001
(73) Patentinhaber: Siemens Production and Logistics Systems AG, 90475 Nürnberg (DE)
(72) Erfinder: SCHULZ, Ralf, D-81241 München (DE); MEHDIANPOUR, Mohammad, D-81829 München (DE)
(74) Vertreter: Berg, Peter, Dipl.-Ing.
(86) Internationale Anmeldenummer: DE0000314
(87) Internationale Veröffentlichungsnummer: WO00051408

(56) Entgegenhaltungen:
- US-A- 4 619 043
- US-A- 4 875 285

## Beschreibung

Die Erfindung bezieht sich auf eine Vorrichtung zum Bestücken von Substraten mit elektrischen Bauelementen mittels eines verfahrbaren Bestückkopfes zum Handhaben der Bauelemente, die von zumindest einem Greifer des Bestückkopfs an Zuführeinrichtungen aufnehmbar, zu Bestückplätzen auf dem Substrat transportierbar und dort auf das Substrat aufsetzbar sind.

Eine derartige Einrichtung ist z.B. durch die US 4,875,285 bekannt geworden. Ein revolverkopfartiger Bestückkopf weist eine Vielzahl von als Saugpipetten ausgebildete Greifer auf, die die Bauelemente an den Zuführeinrichtungen aufnehmen. Von dort verfährt der Bestückkopf zu einer in der Vorrichtung fixierten Leiterplatte, auf die die Bauelemente sukzessive aufgesetzt werden. Dabei beschränkt sich die Anzahl der transportierten Bauelemente auf die Anzahl der Saugpipetten. Nach dem Aufsetzen muß der Bestückkopf erneut zu den außerhalb des Bestückbereichs angeordneten Zuführeinrichtungen verfahren.

Insbesondere große Bauelemente, z.B. vielpolige IC's, können aus Platzgründen nicht mit dem Revolverkopf gehandhabt werden. Für solche Bauelemente sind Köpfe mit nur einem Greifer vorgesehen, mit denen jeweils nur ein Bauteil transportiert werden kann.

Der Erfindung liegt die Aufgabe zugrunde, bei geringem baulichen Aufwand die Bestückleistung zu erhöhen.

Diese Aufgabe wird durch die Erfindung gemäß Anspruch 1 gelöst. Der Speicher kann so groß ausgebildet werden, daß er eine Vielzahl von Bauelementen aufnehmen kann. Dabei wird der Bestückkopf im Bereich der Zuführeinrichtungen solange Bauelemente aufnehmen, bis der Speicher gefüllt ist. Sodann verfährt der Bestückkopf über das zu bestückende Substrat, wo der Greifer die Bauelemente aus dem Speicher entnimmt und sukzessive auf die vorgesehenen Bestückplätze aufsetzt. Ein derartiger Bestückkopf benötigt nur einen einzigen Greifer zum Füllen und Entleeren des Speichers. Da dabei nur geringe Relativbewegungen zwischen dem Greifer und dem Speicher stattfinden, können diese Vorgänge mit hoher Taktrate ähnlich wie beim Revolverkopf ablaufen.

Der Speicher kann mechanisch weitaus einfacher gestaltet werden als die Greifer des Revolverkopfes. Er kann außerdem so groß gehalten werden, daß er eine erheblich größere Anzahl von Bauelementen aufnimmt, wodurch der Bestückkopf weniger oft zwischen den Zuführeinrichtungen und dem Substrat verfahren muß.

Vorteilhafte Weiterbildungen der Erfindung sind in den Ansprüchen 2 bis 18 gekennzeichnet:
Durch die Weiterbildung nach Anspruch 2 können die Bauelemente zwischen dem Greifer und dem Speicher in einfachen Bewegungsabläufen transportiert werden.
Durch das Schwenkteil nach Anspruch 3 läßt sich die Relativbewegung des Greifers zwischen der Aufsetz- und der Übergabestellung in einfacher Weise realisieren.
Durch die Weiterbildung nach den Ansprüchen 4 und 5 kann das Bauteil in einfacher Weise von den Zuführeinrichtungen abgeholt, an den Speicher übergeben, aus diesem entnommen und auf das Substrat aufgesetzt werden.
Durch die Weiterbildung nach Anspruch 6 kann die Übergabe zwischen dem Greifer und dem Speicher derart gesteuert werden, daß das Bauelement in jeder Phase sicher gehalten ist.

Durch die Weiterbildung nach Anspruch 7 wird das Positionieren der Bauelemente auf dem Schiebeteil vereinfacht. Es ist möglich, einer der Schrittstellungen des Schiebeteils eine z.B. optische Abtasteinrichtung zur Lagebestimmung der Bauelemente zuzuordnen. Da das Übergeben der Bauelemente vom Schiebeteil zum Greifer definiert erfolgt, ist es möglich, die aus der Abtasteinrichtung gewonnenen Positionsdaten zur Winkel- und Lagekorrektur der Bauelemente zu verwenden.

Die Saugöffnungen nach Anspruch 8 stellen einfache Haltemittel für die Bauelemente am Schiebeteil dar.

Durch die Weiterbildungen nach den Ansprüchen 9 und 10 können die Bauelemente in einfacher Weise am Schiebeteil gehalten und übergeben werden.

Das ringförmige Schiebeteil nach Anspruch 11 stellt ein einfaches und einfach zu betätigendes Konstruktionsteil dar.

Die Anordnung nach Anspruch 12 ermöglicht in einfacher Weise das senkrechte Aufsetzen der Bauelemente auf die Speicherplätze bzw. auf das Substrat.

Durch die Weiterbildung nach Anspruch 13 können die Wechselvorgänge beim Abholen der Bauelemente von den Zuführeinrichtungen und beim Füllen des Speichers beschleunigt werden, in dem sich jeweils einer der Greifer in der Abholstellung und ein anderer in der Übergabestellung befindet. In gleicher Weise kann das Entleeren des Speichers und das Bestücken des Substrats beschleunigt werden.

Das Schwenkteil nach Anspruch 14 benötigt nur zwei Greifer, die in einer Pendelbewegung abwechselnd die Aufsetzstellung bzw. die Übergabestellung einnehmen. Hierbei muß jedoch jedem einzelnen der Greifer eine eigene Übergabestellung zugeordnet werden. Dies ist bei einem zur Aufsetzstellung konzentrischen Schiebeteil in einfacher Weise realisierbar, in dem die beiden Übergabestationen einander diametral gegenüberliegen. Ein Füllzyklus kann dann mit einer halben Umdrehung des Schiebeteils durchgeführt werden, wobei jeder der beiden Greifer eine Ringhälfte füllt.

Durch den Rotor nach Anspruch 15 kann das Schwenkteil in einer rotatorischen Bewegung indexiert ohne Richtungswechsel betätigt werden. Da nun die Greifer nicht mehr primär der Speicherung der Bauelemente dienen, kann ihre Anzahl auf die Anzahl der vorgesehenen Arbeitsstationen ohne Leistungseinbuße verringert werden Wenn z.B. zusätzlich zur Aufsetz- und zur Übergabestation noch eine Abtast- und eine Verdrehstation vorgesehen sind, werden nur noch vier Greifer benötigt.

Durch die Weiterbildung nach Anspruch 16 erfolgt das Übergeben der Bauelemente im Arbeitstakt des Bestückkopfes ohne Zeitverlust.

Die Anordnung nach Anspruch 17 ermöglicht es, die Lagekontrolle und Lagekorrektur der Bauelemente nach der Entnahme aus dem Speicher und unmittelbar vor dem letzten Handhabungsschritt des Aufsetzens auf das Substrat vorzunehmen.

Durch den zusätzlichen Speicher nach Anspruch 18 kann die Speicherkapazität erheblich erhöht werden. Bei einem revolverartigen Bestückkopf ist es leicht möglich, die zweite Übergabestation einer bisher nicht genutzten Haltestation zuzuordnen.

Im folgenden wird die Erfindung anhand eines in der Zeichnung dargestellten Ausführungsbeispieles näher erläutert.
- Figur 1: zeigt schematisiert einen Bestückkopf mit zwei V-förmig zueinander stehenden Greifern,
- Figur 2: den Bestückkopf nach Figur 1 in einer anderen Arbeitsphase,
- Figur 3: schematisiert eine Seitenansicht eines anderen Bestückkopfes mit revolverartig angeordneten Greifern,
- Figur 4: eine Stirnansicht des Bestückkopfes nach Figur 3.

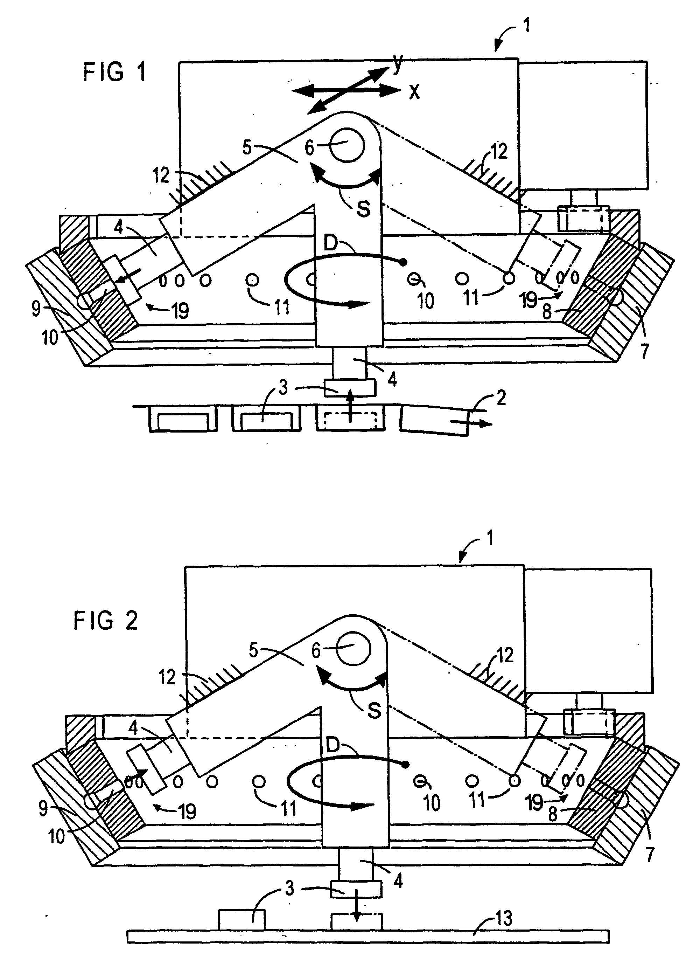

Nach Figur 1 ist ein Bestückkopf 1 in der Richtung der angegebenen Pfeile X und Y in zwei Koordinatenrichtungen mittels eines nicht dargestellten Positioniersystems z.B. zwischen Zuführeinrichtungen und einem Substrat verfahrbar. Derartige Zuführeinrichtungen weisen z.B. zueinander parallel verlaufende Bauteilebänder 2 mit Taschen auf, in denen elektronische Bauelemente 3 aufgenommen sind. Die Taschen können durch schrittweises Verschieben des Bauteilebandes 2 in eine Abholposition verschoben werden, in der das jeweilige Bauelement 3 von einem Greifer 4 in der angegebenen senkrechten Pfeilrichtung aus dem Bauteileband 2 z.B. durch Ansaugen entnommen werden kann.

Der Greifer 4 ist in einem Schwenkteil 5 geführt und in der zur Verfahrebene senkrechten Abholrichtung verschiebbar. Er wird mit seinem Halteende auf das bereitliegende Bauelement abgesenkt, daß in den Wirkbereich eines Saugkanals des Greifers gelangt. Durch Zurückziehen des Greifers wird das Bauelement 3 aus dem Bauteileband entnommen und in die dargestellte Transportstellung angehoben.

Das Schwenkteil 5 ist um eine waagerechte Achse 6 gemäß dem Rundpfeil S schwenkbar. Es weist einen weiteren Greifer 4 auf, der in der Schwenkebene des Schwenkteils 5 zum anderen Greifer 4 v-förmig stehend angeordnet ist, derart, daß sich die Längsachsen der Greifer 4 im Zentrum der Achse 6 treffen.

Der Bestückkopf 1 weist außerdem einen ringförmigen, zum senkrecht stehenden Greifer 4 konzentrischen Speicher 7 auf, der mit einem ringförmigen Schiebeteil 8 versehen ist, das an einem stationären Ringteil 9 des Speichers 7 gemäß dem Drehpfeil D drehbar gelagert ist. Eine freie Innenseite des Schiebeteils 9 ist konisch ausgebildet und mit Saugöffnungen 10 versehen, die in gleichmäßigen Teilungsabständen umlaufend angeordnet sind. Diese Saugöffnungen 10 definieren Speicherplätze 11 für die Bauelemente 3.

Das Schwenkteil 5 ist zwischen Anschlägen 12 des Bestückkopfes 1 derart schwenkbar, daß sich jeweils einer der Greifer 4 in der senkrechten Abholstellung und der andere Greifer in einer schrägen Übergabestellung befindet, in der er einer Übergabestation 19 des Bestückkopfes 1 zugeordnet ist. Zur gleichen Zeit ist das Schiebeteil 8 in eine Stellung verdreht, in der einer der freien Speicherplätze 11 ebenfalls der Übergabestation 19 zugeordnet ist, wobei der Greifer 4 senkrecht zum Speicherplatz 11 gerichtet ist. Durch eine senkrechte Aufsetzbewegung des Greifers 4 kann das zuvor abgeholte Bauelement 3 auf dem Speicherplatz 11 des Schiebeteils 8 abgelegt werden. Bei diesen Übergabevorgängen können die Druckverhältnisse in der Saugöffnung 10 und dem Saugkanal des Greifers 4 derart gesteuert werden, daß das Bauelement 3 in jeder Phase sicher gehalten wird und ohne seitliches Versetzen übergeben werden kann.

Durch Schwenken des Schwenkteils 5 kann anschließend der freie Greifer 4 in die Abholstellung geschwenkt werden, wobei der andere Greifer 4 in eine andere Übergabestellung gelangt, in der er einer weiteren Übergabestation 19 zugeordnet ist, die der anderen diametral gegenüberliegt. Das Schiebeteil 8 ist dabei so getaktet, daß sich jeweils einer der Speicherplätze 11 in der Übergabestation 19 befindet, wobei der Speicher 7 bereits nach einer halben Umdrehung des Schiebeteils 8 vollständig gefüllt ist.

Der Bestückkopf 1 kann sodann gemäß Figur 2 in einem Bestückbereich der Bestückvorrichtung über ein Substrat 13 verfahren werden, auf das die Bauelemente 3 in einem zum Füllen reversiblen Bewegungsablauf sukzessive aus dem Speicher 7 entnommen werden und auf das Substrat 13 aufgesetzt werden.

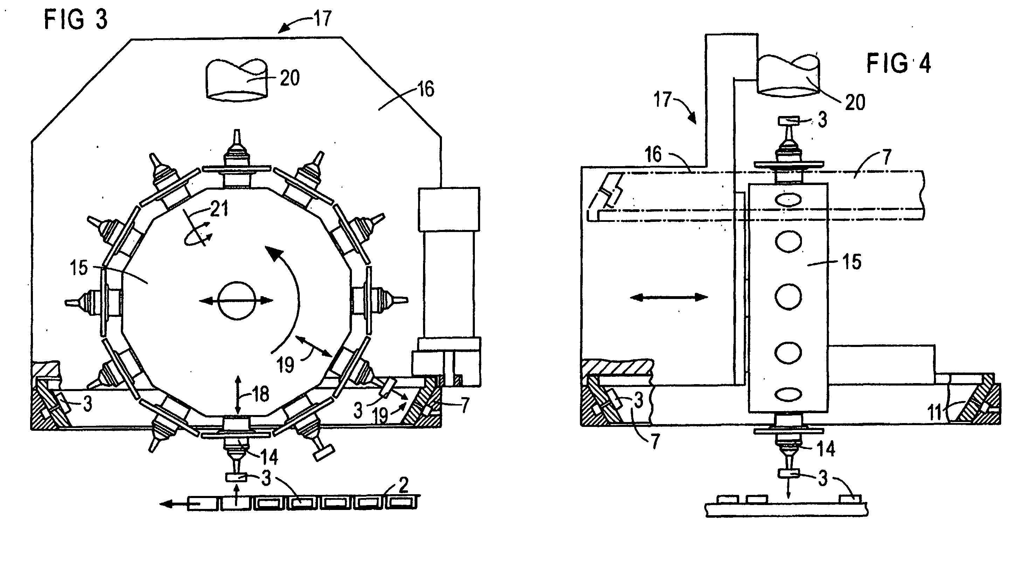

Nach den Figuren 3 und 4 ist eine Vielzahl von Greifern 14 auf einem Rotor 15 angeordnet, der an einem Stator 16 eines anderen Bestückkopfes 17 schrittweise drehbar gelagert ist. Verschiedene Winkelstellungen der Greifer 14 sind verschiedenen Arbeitsstationen zugeordnet. Diese sind z.B. als Aufsetzstation 18, Übergabestation 19, Abtaststation 20 und Verdrehstation 21 ausgebildet.

In der Aufsetzstation 18 werden die Bauelemente 3 aus dem Bauteileband 2 entnommen und in zwei Schritten bis zur Übergabestation verschwenkt. In deren Höhe befindet sich der ringförmige Speicher 7 mit dem konischen Schiebeteil 8, auf dessen Speicherplätze 11 die Bauelemente 3 sukzessive aufgesetzt werden können. Nachdem diese gefüllt sind, können die Greifer 14 des Rotors 15 in einem weiteren Umlauf mit zusätzlichen Bauelementen 3 belegt werden, wobei insbesondere solche Bauteile in Frage kommen, die für die Zwischenspeicherung im Speicher 7 weniger geeignet sind.

Danach verfährt der Bestückkopf 17 bis über das zu bestückende Substrat 13 in die in Figur 4 dargestellte Lage. Hier werden zunächst die an den Greifern 14 befindlichen Bauelemente 3 an der Aufsetzstation 18 auf das Substrat 13 aufgesetzt. Bei diesem Umlauf wird in der optischen Abtaststation 20 die genaue Lage der Bauelemente 3 ermittelt. In der nachfolgenden Verdrehstation 21 wird die Winkellage der Bauelemente 3 durch Verdrehen des Greifers 14 um seine Längsachse korrigiert, die zur Drehachse des Rotors radial stehend angeordnet ist.

Sobald freigewordene Greifer 14 die Übergabestation 19 erreichen, entnehmen sie dem synchron mitlaufenden Schiebeteil 8 des Greifers 7 sukzessive die Bauelemente 3 und setzen sie nach dem Durchlaufen der Abtaststation 20 und Verdrehstation 21 ebenfalls auf das Substrat 13 auf. Nachdem sämtliche Bauelemente 3 auf das Substrat 13 aufgesetzt worden sind, kann der Bestückkopf 17 für einen neuen Abholzyklus über die Zuführeinrichtungen verfahren werden.

Es ist möglich, im Bestückkopf 17 zumindest einen weiteren Speicher 7 und eine weitere Übergabestation vorzusehen, wie dies in Figur 4 strichpunktiert angedeutet ist. Dadurch kann die Speicherkapazität des Bestückkopfes 17 entsprechend erhöht werden.

## Patentansprüche

1. Vorrichtung zum Bestücken von Substraten (13) mit elektrischen Bauelementen (3) mittels eines verfahrbaren Bestückkopfes (1, 17) zum Handhaben der Bauelemente (3), die von zumindest einem Greifer (4,14) des Bestückkopfes (1, 17) an Zuführeinrichtungen aufnehmbar, zu Bestückplätzen auf dem Substrat (13) transportierbar und dort auf das Substrat (13) aufsetzbar sind,
**dadurch gekennzeichnet,**
**daß** der Bestückkopf (1, 17) zumindest einen vom Greifer (4, 14) getrennten Speicher (7) mit mehreren Speicherplätzen (11) für die Bauelemente (3) aufweist,
**daß** der Greifer (4, 14) und die Speicherplätze (11) relativ zueinander bewegbar sind,
**daß** die vom Greifer (4, 14) aufgenommenen Bauelemente (3) an den Speicherplätzen (11) des Speichers (7) ablegbar sind und daß die abgelegten Bauelemente (3) mittels des Greifers (4, 14) von den Speicherplätzen (11) entnehmbar und auf das Substrat (13) aufsetzbar sind.

2. Vorrichtung nach Anspruch 1
**dadurch gekennzeichnet,**
**daß** die Bauelemente (3) an einem Halteende des Greifers (4, 14) fixierbar sind,
**daß** das Halteende quer zur Aufsetzrichtung der Bauelemente (3) in eine Übergabestellung bewegbar ist, die einer Übergabestation des Bestückkopfes (1, 17) zugeordnet ist und
**daß** die Speicherplätze (11) im Bestückkopf (1, 17) sukzessive zur Übergabestation verschiebbar sind.

3. Vorrichtung nach Anspruch 2,
**dadurch gekennzeichnet,**
**daß** der Greifer (4, 14) in einem Schwenkteil (5) des Bestückkopfes (1, 17) gelagert sind und
**daß** das Halteende mittels des Schwenkteils quer zur Aufsetzrichtung zwischen einer Aufsetzstation und der Übergabestation schwenkbar ist.

4. Vorrichtung nach Anspruch 3,
**dadurch gekennzeichnet,**
**daß** der Greifer (4,14) in einer Führung des Schwenkteils (5) in der Aufsetzrichtung längsverschiebbar gelagert ist.

5. Vorrichtung nach Anspruch 4,
**dadurch gekennzeichnet,**
**daß** das Halteende in der Übergabestation (19) in die Richtung des dort befindlichen Speicherplatzes (11) längsverschiebbar ist.

6. Vorrichtung nach einem der Ansprüche 1 bis 5,
**dadurch gekennzeichnet,**
**daß** der Greifer (4, 14) als Sauggreifer ausgebildet ist und
**daß** die Druckverhältnisse im Greifer (4, 14) in der Übergabestellung derart steuerbar sind, daß die Haltekraft des Greifers (4, 14) die Haltekraft des Speicherplatzes (11) übersteigt oder unterschreitet.

7. Vorrichtung nach einem der Ansprüche 2 bis 6,
**dadurch gekennzeichnet,**
**daß** die Speicherplätze (11) rasterartig an einem Schiebeteil (8) verteilt sind, das am Bestückkopf (1, 17) schrittweise verschiebbar gelagert ist und
**daß** die Speicherplätze (11) sukzessive zur Übergabestation verschiebbar sind.

8. Vorrichtung nach Anspruch 7,
**dadurch gekennzeichnet,**
**daß** das Schiebeteil (8) an den Speicherplätzen (11) mit Saugöffnungen (10) für die Bauelemente (3) versehen ist.

9. Vorrichtung nach Anspruch 8,
**dadurch gekennzeichnet,**
**daß** die Saugöffnungen (10) des Speichers (7) permanent an eine gemeinsame Saugleitung angeschlossen sind.

10. Vorrichtung nach Anspruch 9,
**dadurch gekennzeichnet,**
**daß** der Speicher (7) an der Übergabestation mit Mitteln zur Druckumschaltung in der Saugöffnung (10) versehen ist._

11. Vorrichtung nach einem der Ansprüche 7 bis 10,
**dadurch gekennzeichnet,**
**daß** das Schiebeteil (8) ringförmig ausgebildet und drehbar gelagert ist

12. Vorrichtung nach Anspruch 11,
**dadurch gekennzeichnet,**
**daß** die Drehachse des Schiebeteils (8) mit der Längsachse des in der Aufsetzstellung befindlichen Greifers (4, 14) dekkungsgleich ist und
**daß** die Speicherplätze (11) für die Bauelemente (3) Auflageflächen aufweisen, die sich senkrecht zur Längsachse des in der Übergabestellung befindlichen Greifers (4, 14) erstrekken.

13. Vorrichtung nach einem der vorhergehenden Ansprüche,
**dadurch gekennzeichnet,**
**daß** das Schwenkteil (5) mit mehreren Führungen für mehrere der Greifer (4, 14) versehen ist, die sukzessive in die Übergabestellung schwenkbar sind.

14. Vorrichtung nach Anspruch 13,
**dadurch gekennzeichnet,**
**daß** im Schwenkteil (5) zwei Greifer (4) mit in einer Schwenkebene v-förmig zueinander stehenden Längsachsen vorgesehen sind,
**daß** die Greifer (4) abwechselnd in die Aufsetzstellung schwenkbar sind, in der sich der jeweils andere Greifer (4) in der Übergabestellung befindet.

15. Vorrichtung nach Anspruch 13,
**dadurch gekennzeichnet,**
**daß** das Schwenkteil als revolverartiger Rotor (15) mit einer Vielzahl von zirkulär angeordneten Greifern (14) ausgebildet ist und
**daß** der Rotor (15) entsprechend der Winkelteilung der Greifer (14) indexiert antreibbar ist.

16. Vorrichtung nach Anspruch 15,
**dadurch gekennzeichnet,**
**daß** entlang einer Umlaufbahn der Greifer (14) an einem Stator (16) des Bestückkopfes (17) Arbeitsstationen vorgesehen sind und
**daß** zumindest eine der Arbeitsstationen die Übergabestation (19) bildet.

17. Vorrichtung nach Anspruch 16,
**dadurch gekennzeichnet,**
**daß** in der Drehrichtung des Rotors (15) zwischen der Übergabestation (19) und der Aufsetzstation (18) eine Abtaststation (20) zur Lageermittlung der Bauelemente (3) und eine Verdrehstation (21) für die Bauelemente (3) angeordnet sind.

18. Vorrichtung nach einem der vorhergehenden Ansprüche,
**dadurch gekennzeichnet,**
**daß** der Bestückkopf (17) zumindest einen weiteren Speicher (7) aufweist, dem zumindest eine weitere Übergabestation zugeordnet ist.

## Claims

1. Apparatus for fitting substrates (13) with electrical components (3) by means of a moveable fitting head (1, 17) for handling the components (3), which can be picked up at feed devices by at least one gripper (4, 14) belonging to the fitting head (1, 17), transported to fitting locations on the substrate (13) and placed onto the substrate (13) there, **characterized in that** the fitting head (1, 17) has at least one storage element (7), separate from the gripper (4, 14) having a plurality of storage spaces (11) for the components (3), **in that** the gripper (4, 14) and the storage spaces (11) can be moved relative to one another, **in that** the components (3) picked up by the gripper (4, 14) can be deposited at the storage spaces (11) of the storage element (7), and **in that** the deposited components (3) can be removed from the storage spaces (11) by means of the gripper (4, 14) and placed onto the substrate (13).

2. Apparatus according to Claim 1, **characterized in that** the components (3) can be fixed at a holding end of the gripper (4, 14), **in that** the holding end can be moved transversely with respect to the placement direction of the components (3) into a transfer position, which is assigned to a transfer station of the fitting head (1, 17), and **in that** the storage spaces (11) in the fitting head (1, 17) can be displaced successively to the transfer station.

3. Apparatus according to Claim 2, **characterized in that** the gripper (4, 14) is mounted n a pivoting part (5) of the fitting head (1, 17) and **in that** the holding end can be pivoted transversely with respect to the placement direction, by means of the pivoting part, between a placement station and the transfer station.

4. Apparatus according to Claim 3, **characterized in that** the gripper (4, 14) is mounted in a guide in the pivoting part (5), such that it can be displaced longitudinally in the placement direction.

5. Apparatus according to Claim 4, **characterized in that** the holding end in the transfer station (19) can be displaced longitudinally in the direction of the storage space (11) located there.

6. Apparatus according to one of Claims 1 to 5, **characterized in that** the gripper (4, 14) is constructed as a suction gripper and **in that** the pressure conditions in the gripper (4, 14) in the transfer position can be controlled in such a way that the holding force of the gripper (4, 14) falls above or below the holding force of the storage space (11).

7. Apparatus according to one of Claims 2 to 6, **characterized in that** the storage spaces (11) are distributed in a grid-like fashion on a sliding part (8), which is mounted on the fitting head (1, 17) such that it can be displaced step by step, and **in that** the storage spaces (11) can be displaced successively to the transfer station.

8. Apparatus according to Claim 7, **characterized in that** the sliding part (8) on the storage spaces (11) is provided with suction openings (10) for the components (3).

9. Apparatus according to Claim 8, **characterized in that** the suction openings (10) of the storage element (7) are permanently connected to a common suction line.

10. Apparatus according to Claim 9, **characterized in that** the storage element (7) on the transfer station is provided with means for changing over the pressure in the suction opening (10).

11. Apparatus according to one of Claims 7 to 10, **characterized in that** the sliding part (8) is of annular design and rotatably mounted.

12. Apparatus according to Claim 11, **characterized in that** the axis of rotation of the sliding part (8) is congruent with the longitudinal axis of the gripper (4, 14) located in the placement position, and **in that** the storage spaces (11) for the components (3) have supporting surfaces which extend perpendicular to the longitudinal axis of the gripper (4, 14) located in the transfer position.

13. Apparatus according to one of the preceding claims, **characterized in that** the pivoting part (5) is provided with a plurality of guides for a plurality of the grippers (4, 14), which can be pivoted successively into the transfer position.

14. Apparatus according to Claim 13, **characterized in that** in the pivoting part (5), two grippers (4) are provided which have longitudinal axes in a V shape with respect to each other in a pivoting plane, and **in that** the grippers (4) can be pivoted alternately into the placement position, in which the respective other gripper (4) is located in the transfer position.

15. Apparatus according to Claim 13, **characterized in that** the pivoting part is constructed as a turret-like rotor (15) having a multiplicity of circularly arranged grippers (14), and **in that** the rotor (15) can be driven and indexed in accordance with the angular pitch of the grippers (14).

16. Apparatus according to Claim 15, **characterized in that** working stations are provided along a circulation path of the grippers (14), on a stator (16) of the fitting head (17), and **in that** at least one of the working stations forms the transfer station (19).

17. Apparatus according to Claim 16, **characterized in that** in the direction of rotation of the rotor (15), between the transfer station (19) and the placement station (18), there are arranged a sensing station (20) for determining the position of the components (3) and a rotation station (21) for the components (3).

18. Apparatus according to one of the preceding claims, **characterized in that** the fitting head (17) has at least one further storage element (7), which is assigned at least one further transfer station.

## Revendications

1. Dispositif pour mettre en place des composants électriques (3) sur des substrats (13) au moyen d'une tête d'équipement déptaçable (1, 17) pour la manipulation des composants (3) qui peuvent être pris sur des dispositifs d'alimentation par au moins une pince (4, 14) de la tête d'équipement (1, 17), peuvent être transportés à des emplacements de mise en place sur les substrats (13) et peuvent y être placés sur le substrat (13) **caractérisé en ce que**
la tête d'équipement (1, 17) présente au moins une unité de stockage (7), séparée de la pince (4, 14), ayant plusieurs emplacements de stockage (11) pour les composants (3),
**en ce que** la pince (4, 14) et les emplacements de stockage (11) sont déplaçables de manière relative les uns par rapport aux autres,
**en ce que** les composants (3) pris par la pince (4, 14) peuvent être déposés aux emplacements de stockage (11) de l'unité de stockage (7) et
**en ce que** les composants (3) déposés peuvent être retirés des emplacements de stockage (11) au moyen de la pince (4, 14) et être placés sur le substrat (13).

2. Dispositif selon la revendication 1,
**caractérisé en ce que**
les composants (3) peuvent être fixés sur une extrémité de maintien de la pince (4; 14),
**en ce que** l'extrémité de maintien est déplaçable transversalement par rapport au sens de placement des composants (3) dans une position de transfert qui est attribuée à une station de transfert de la tête d'équipement (1, 17) et **en ce que** les emplacements de stockage (11) dans la tête d'équipement (1, 17) sont déplaçables successivement vers la station de transfert.

3. Dispositif selon la revendication 2,
**caractérisé en ce que**
la pince (4, 14) est logée dans une pièce pivotante (5) de la tête d'équipement (1, 17) et
**en ce que** l'extrémité de maintien est orientable transversalement par rapport au sens de placement au moyen de la pièce pivotante, entre une station de placement et la station de transfert.

4. Dispositif selon la revendication 3,
**caractérisé en ce que**
la pince (4, 14) est logée de manière déplaçable en longueur dans le sens de placement dans un guidage de la pièce pivotante (5).

5. Dispositif selon la revendication 4,
**caractérisé en ce que**
l'extrémité de maintien est déplaçable en longueur dans la station de transfert (19) dans le sens de l'emplacement de stockage (11) qui s'y trouve.

6. Dispositif selon l'une des revendications 1 à 5,
**caractérisé en ce que**
la pince (4, 14) est formée comme pince aspirante et **en ce que** les rapports de pression dans la pince (4, 14) sont contrôlables en position de transfert, de telle manière que la force de maintien de la pince (4, 14) dépasse la force de maintien de l'emplacement de stockage (11) ou lui est inférieure.

7. Dispositif selon l'une des revendications 2 à 6,
**caractérisé en ce que**
les emplacements de stockage (11) sont répartis de manière similaire à une trame sur une pièce coulissante (8) qui est logée de manière déplaçable pas à pas sur la tête d'équipement (1, 17) et
**en ce que** les emplacements de stockage (11) sont déplaçables successivement vers la station de transfert.

8. Dispositif selon la revendication 7,
**caractérisé en ce que**
la pièce coulissante (8) est munie d'orifices d'aspiration (10) des composants (3) aux emplacements de stockage (11).

9. Dispositif selon la revendication 8,
**caractérisé en ce que**
les orifices d'aspiration (10) de l'unité de stockage (7) sont raccordés en permanence à une conduite d'aspiration commune.

10. Dispositif selon la revendication 9,
**caractérisé en ce que**
l'unité de stockage (7) est munie sur la station de transfert de moyens pour la commutation de pression dans l'orifice d'aspiration (10).

11. Dispositif selon l'une des revendications 7 à 10,
**caractérisé en ce que**
la pièce coulissante (8) est formée de manière annulaire et qu'elle est pivotante.

12. Dispositif selon la revendication 11,
**caractérisé en ce que**
l'axe de rotation de la pièce coulissante (8) coïncide avec l'axe longitudinal de la pince (4, 14) se trouvant en position de placement et
**en ce que** les emplacements de stockage (11) des composants (3) présentent des surfaces d'appui qui s'étendent verticalement par rapport à l'axe longitudinal de la pince (4, 14) se trouvant en position de transfert.

13. Dispositif selon l'une des revendications précédentes,
**caractérisé en ce que**
la pièce pivotante (5) est munie de plusieurs guidages pour plusieurs des pinces (4,14), qui sont successivement pivotantes en position de transfert.

14. Dispositif selon la revendication 13,
**caractérisé en ce que**
deux pinces (4) ayant des axes longitudinaux en forme de V l'un par rapport à l'autre sur un niveau de pivotement sont prévues dans la pièce pivotante (5),
**en ce que** les pinces (4) sont pivotantes en alternance en position de placement, dans laquelle l'autre pince (4) respective se trouve en position de transfert.

15. Dispositif selon la revendication 13,
**caractérisé en ce que**
la pièce pivotante est formée comme rotor (15) similaire à une tourelle revolver avec un grand nombre de pinces (14) disposées de manière circulaire, et
**en ce que** le rotor (15) peut être entraîné de manière indexée correspondant à la division angulaire des pinces (14).

16. Dispositif selon la revendication 15,
**caractérisé en ce que**
des stations de travail sont prévues sur un stator (16) de la tète d'équipement (17) le long d'une voie de circulation des pinces (14)
et **en ce que** au moins une des stations de travail forme la station de transfert (19)

17. Dispositif selon la revendication 16,
**caractérisé en ce que**
une station d'exploration (20) pour la détection de la position des composants (3) est disposée dans le sens de rotation du rotor (15) entre la station de transfert (19) et la station de placement (18) et **en ce qu'**une station de déplacement angulaire (21 ) des composants est prévue.

18. Dispositif selon l'une des revendications précédentes
**caractérisé en ce que**
la tête d'équipement (17) présente au moins une unité de stockage supplémentaire (7) à laquelle au moins une station de transfert supplémentaire est attribuée.
